# EUROPEAN PATENT APPLICATION

(11) **EP 4 718 499 A1**
(43) Date of publication of application: **01.04.2026**
(21) Application number: 25204517.4
(22) Date of filing: 25.09.2025
(51) Int. Cl.: H01L 21/48, H01L 23/15, H01L 23/538, H01L 21/56, H01L 23/498, H01L 25/065

(54) **PACKAGING SUBSTRATE HAVING EMBEDDED BRIDGE AND MANUFACTURING METHOD OF THE SAME**

(30) Priority: 27.09.2024 US 202463699821 P; 27.09.2024 US 202463699819 P
(71) Applicant: Absolics Inc., Covington, GA 30014 (US)
(72) Inventor: KIM, Sungjin, Covington, GA 30014 (US)
(74) Representative: BCKIP Part mbB

(57) **Abstract**

An embodiment relates to a packaging substrate having an embedded bridge, and comprises: a glass core having a cavity and through-electrodes; a bridge disposed in the cavity; an integrated electrode disposed on one surface of the bridge and on one surface of the glass core; and an insulating material disposed between the glass core and the bridge and between the integrated electrode. The bridge comprises: a bridge core, which is a support; and a bridge electrode disposed inside the bridge core, electrically interconnecting at least two points on one face of the bridge, with both ends exposed to a surface of the bridge core. The integrated electrode is an electrically conductive layer electrically connected to at least one of the through-electrodes and the bridge electrode.

## Description

This application claims the priorities of U.S. Provisional Patent Application No. 63/699,821, filed September 27, 2024 and U.S. Provisional Patent Application No. 63/699,819, filed September 27, 2024.

### BACKGROUND

### Technical Field

Embodiments are directed to a packaging substrate having a bridge embedded in a glass core and a manufacturing method of the same.

### Description of Related Art

When building an electronic component, implementing the circuitry on a semiconductor wafer is called the front-end (FE), and assembling the wafer into a product-ready state is called the back-end (BE), which includes the packaging process.

There are four core technologies in the semiconductor industry that have enabled the rapid development of electronic products in recent years: semiconductor technology, semiconductor packaging technology, manufacturing process technology, and software technology. Semiconductor technology is advancing in various forms, including sub-micron to nano-scale line widths, more than 10 million cells, high-speed operation, and high heat dissipation, but the technology to package them perfectly is relatively weak. Therefore, the electrical performance of semiconductors is often determined by packaging technology and electrical connections rather than the performance of the semiconductor technology itself.

Ceramic or resin has been used as the material for packaging substrates, but recently, researchers have been applying silicon or glass as high-end packaging substrates, and in particular, packaging substrates with a cavity structure have been developed by applying glass substrates.

Relevant prior art includes U.S. Patent Publication US 2022/0028788 A1 and U.S. Patent Publication US 2021/0028080 A1.

### SUMMARY

In some embodiments, a packaging substrate having a bridge embedded in a glass core, and a manufacturing method of the same, wherein the manufacturability, power efficiency, etc. of the packaging substrate is improved, is disclosed.

In some embodiments, a packaging substrate having an embedded bridge and a manufacturing method of the same while overcoming the processing difficulties of glass plate, is disclosed.

According to an embodiment, a packaging substrate having an embedded bridge includes: a glass core having a cavity and through-electrodes; a bridge disposed in the cavity; an integrated electrode disposed on one face of the bridge and on one face of the glass core; and an insulating material disposed between the glass core and the bridge and between the integrated electrode.

The bridge includes: a bridge core, which is a support; and a bridge electrode disposed inside the bridge core, electrically coupled to at least two points on one face of the bridge, with both ends exposed to a surface of the bridge core.

The integrated electrode is an electrically conductive layer electrically connected to at least one of the through-electrodes and the bridge electrode.

A lower portion of the cavity may further include a fixture.

The fixture may be arranged to face the integrated electrode with the bridge therebetween.

The packaging substrate may further include a first die and a second die disposed over the integrated electrode.

An electrical signal may be transmitted between the first die and the second die via the bridge electrode.

The integrated electrode may include a first integrated electrode disposed on the glass core or on the bridge; and a second integrated electrode disposed on the first integrated electrode.

The first integrated electrode may include a first vertically oriented electrically conductive layer directly connected to the through-electrode or the bridge electrode, a first laterally oriented electrically conductive layer, and combinations thereof.

The second integrated electrode may include a second vertically oriented electrically conductive layer connected to the electrically conductive layer of the first integrated electrode, a second laterally oriented electrically conductive layer, and combinations thereof.

A lower insulating cover may be disposed over a lower portion of the glass core.

The fixture may be located between the bridge and the lower insulating cover.

The fixture may include an adhesive layer.

An encapsulating layer wrapping the first die and the second die, and a lead frame wrapping the encapsulating layer, may be further disposed over the packaging substrate.

The bridge may further include a bridge penetrating electrode extending in a thickness direction through the bridge core.

The integrated electrode may be an electrically conductive layer electrically connected to at least one of the through-electrodes, the bridge electrode, and the bridge penetrating electrode.

The bridge core may include plate silicon or plate silicon carbide.

The packaging substrate may further include a third integrated electrode disposed on the second integrated electrode.

The third integrated electrode may include a third vertically oriented electrically conductive layer connected to the electrically conductive layer of the second integrated electrode, a third laterally oriented electrically conductive layer, and combinations thereof.

The bridge penetrating electrode may further include a bridge electrode pad disposed above or below the bridge core.

The glass core may be a glass plate etched to have the cavity and the core vias.

According to an embodiment, a method of manufacturing a packaging substrate having an embedded bridge includes: a preparation operation of preparing a glass core having a cavity and core vias; a fixation operation of disposing a bridge in the cavity and fixing its position; a patterning operation of disposing integrated electrodes on the glass core and the bridge; and a removal operation of removing a lower portion of the glass core, thereby manufacturing the packaging substrate having an embedded bridge described above.

The fixation operation may be an operation of fixing by forming an adhesive layer between one face of the cavity and one face of the bridge.

The glass core may be divided in the thickness direction into a first portion in which the cavity is disposed and a second portion in which the cavity is not disposed.

The removal operation may be an operation of removing part or all of the second portion.

The glass core may be a laminated glass in which a first glass and a second glass are laminated together.

The first glass may have a cavity and a through-via.

The second glass may not have a through-cavity disposed therein.

### BRIEF DESCRIPTION OF THE DRAWINGS

FIGS. 1A and 1B are conceptual diagrams schematically illustrating, in cross-section, a glass core applicable to a method of manufacturing a packaging substrate having an embedded bridge according to one embodiment of the present disclosure.
FIG. 2A is a conceptual cross-sectional diagram illustrating an example in which a bridge is disposed in the glass core applicable to the method of manufacturing a packaging substrate having an embedded bridge according to one embodiment.
FIG. 2B is a conceptual cross-sectional diagram illustrating another example in which a bridge is disposed in the glass core applicable to the method of manufacturing a packaging substrate having an embedded bridge according to one embodiment.
FIG. 2C is a conceptual cross-sectional diagram illustrating still another example in which a bridge is disposed in the glass core applicable to the method of manufacturing a packaging substrate having an embedded bridge according to one embodiment.
FIGS. 3A to 3C are conceptual cross-sectional diagrams illustrating examples of a patterning operation in the method of manufacturing a packaging substrate having an embedded bridge according to one embodiment.
FIG. 3D is a conceptual cross-sectional diagram illustrating an operation of forming an upper insulating cover after the patterning operation in the method of manufacturing a packaging substrate having an embedded bridge according to one embodiment.
FIG. 4 is a conceptual cross-sectional diagram illustrating an example of a removal operation applicable to the method of manufacturing a packaging substrate having an embedded bridge according to one embodiment.
FIGS. 5A and 5B are conceptual cross-sectional diagrams respectively illustrating examples of a packaging substrate according to one embodiment.
FIG. 6 is a conceptual cross-sectional diagram illustrating an example of a packaging substrate with dies mounted according to one embodiment.
FIGS. 7A and 7B are conceptual diagrams schematically illustrating, in cross-section, a glass core applicable to a method of manufacturing a packaging substrate having an embedded bridge according to one embodiment of the present disclosure.
FIG. 8A is a conceptual cross-sectional diagram illustrating an example in which a bridge is disposed in the glass core applicable to the method of manufacturing a packaging substrate having an embedded bridge according to one embodiment.
FIG. 8B is a conceptual cross-sectional diagram illustrating another example in which a bridge is disposed in the glass core applicable to the method of manufacturing a packaging substrate having an embedded bridge according to one embodiment.
FIGS. 9A to 9C are conceptual cross-sectional diagrams illustrating examples of a patterning operation in the method of manufacturing a packaging substrate having an embedded bridge according to one embodiment.
FIG. 9D is a conceptual cross-sectional diagram illustrating an operation of forming an upper insulating cover after the patterning operation in the method of manufacturing a packaging substrate having an embedded bridge according to one embodiment.
FIG. 10 is a conceptual cross-sectional diagram illustrating an example of a removal operation applicable to the method of manufacturing a packaging substrate having an embedded bridge according to one embodiment.
FIGS. 11A and 11B are conceptual cross-sectional diagrams respectively illustrating examples of a packaging substrate according to one embodiment.
FIG. 12 is a conceptual cross-sectional diagram illustrating an example of a packaging substrate with dies mounted according to one embodiment.

### DESCRIPTION OF THE EMBODIMENTS

n order to provide a comprehensive understanding of the methods, apparatus, and/or systems described herein, the following detailed description is provided. However, various modifications, revisions, and equivalents of the methods, devices, and/or systems described herein will become apparent after understanding what this disclosure presents. For example, the sequence of operations described herein is by way of example only and is not intended to be limiting to the operations described herein. With the exception of operations that are not necessarily performed in a particular order, the order of operations may be altered based on an understanding of what is disclosed herein. Further, descriptions of features already known in the art may be omitted for clarity and brevity after understanding the disclosure of this application. However, the omission of such features and their descriptions is not intended to be recognized as general knowledge.

The features described herein may be implemented in different forms and are not to be construed as limiting to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit disclosure. The singular form used herein is intended to include the plural form unless the context clearly indicates otherwise. As used herein, the term "and/or" includes any one or a combination of two or more of the relevant list items. As used herein, the terms "includes," "comprises," and "contains" specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

For the purposes of this application, "B being located on A" means that B is placed on top of A, either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Such terms, as defined in commonly used dictionaries, shall be construed to have a meaning consistent with their meaning in the context of the prior art and the present invention and shall not be construed in an idealized or overly formal sense unless expressly defined herein.

Throughout this specification, the term "combination thereof" as used in a Markush-style representation means one or more mixtures or combinations selected from the group of components described in the Markush-style representation, including one or more selected from the group of components.

In one or more of the examples, a description of "A and/or B" means "A, B, or A and B".

In one or more of the examples, terms such as "first," "second," "A," or "B" are used to distinguish identical terms from each other.

In one or more of the examples, "~" based may mean including in the compound a compound corresponding to "~ " or a derivative of "~ ".

In one or more of the above examples, singular forms are contextually interpreted to include the plural as well as the singular, unless otherwise noted.

### Manufacturing method of packaging substrate having embedded bridge (1)

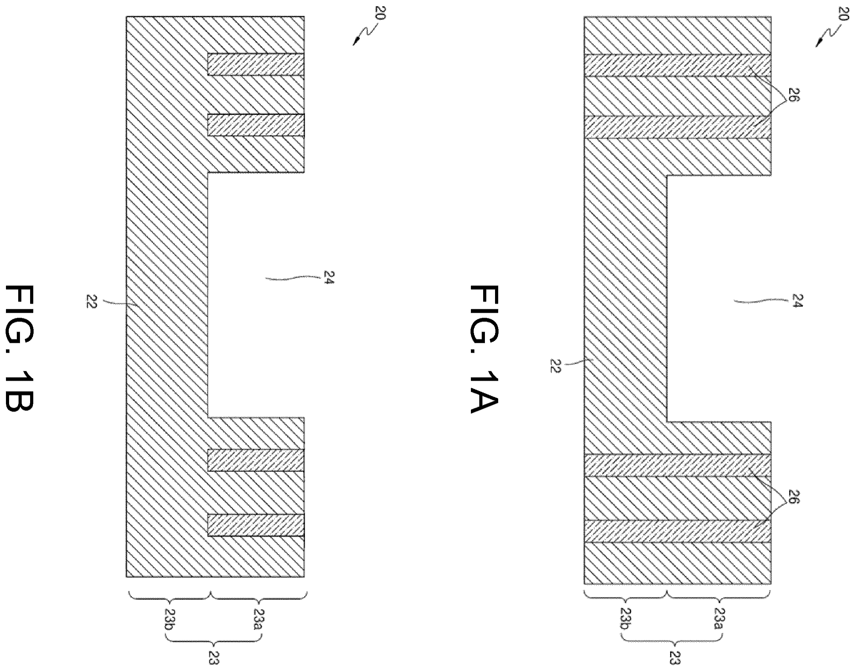

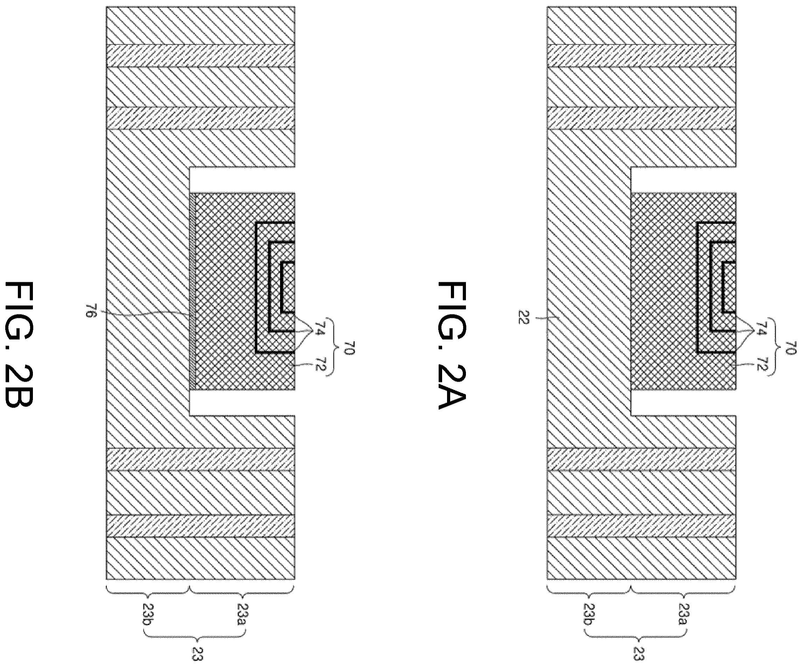

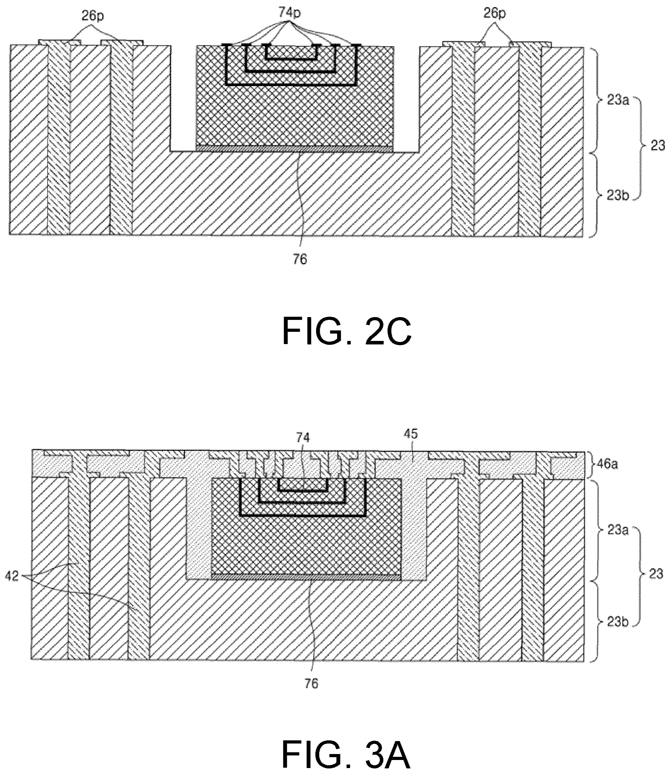

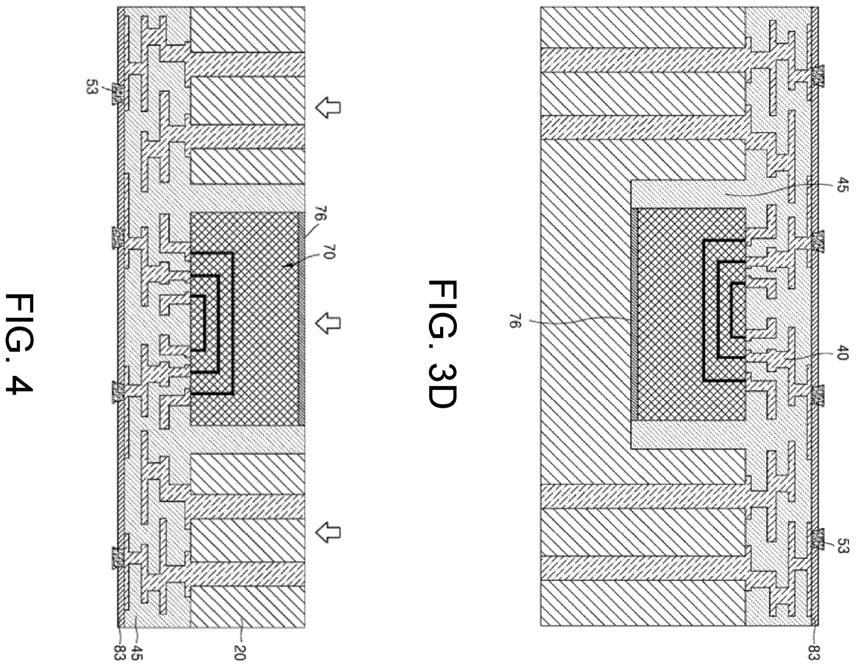

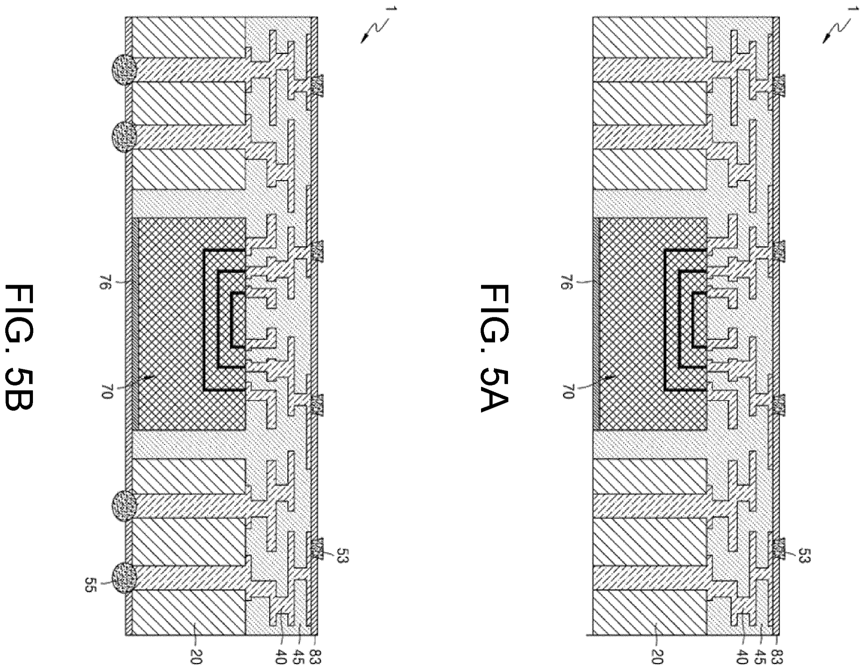

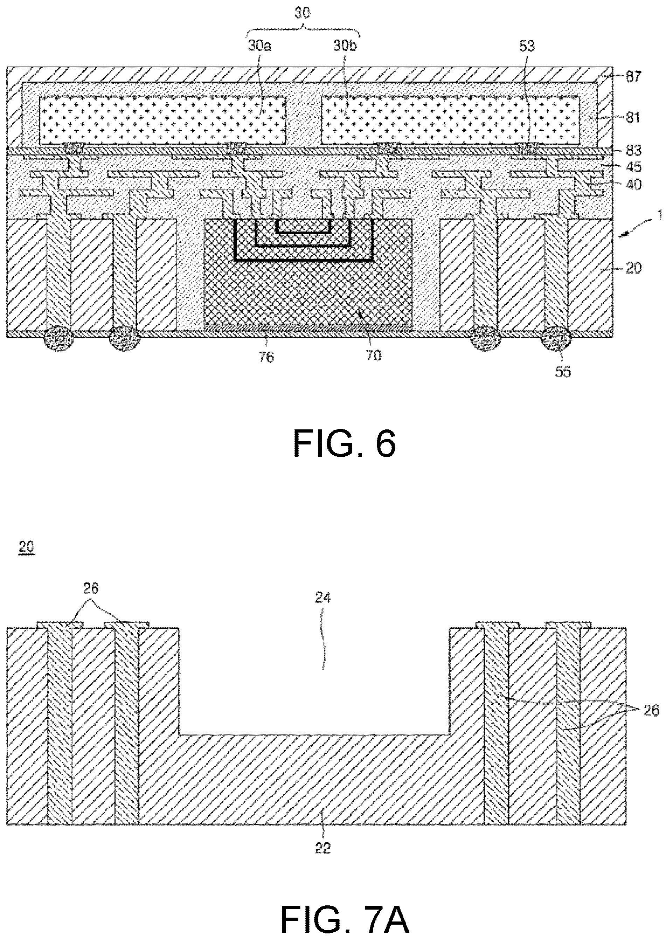

FIGS. 1A and 1B are conceptual diagrams illustrating, in cross-section, an exemplary glass core applied to a manufacturing method of a packaging substrate with an embedded bridge, according to one embodiment of the present invention. FIG. 2A is a cross-sectional conceptual diagram illustrating an example of a bridge disposed in a glass core, applicable to a manufacturing method of a packaging substrate with an embedded bridge, according to one embodiment of the present invention. FIG. 2B is a cross-sectional conceptual diagram illustrating another example of a bridge disposed in a glass core, applicable to a manufacturing method of a packaging substrate with an embedded bridge according to one embodiment of the present invention. FIG. 2C is a cross-sectional conceptual diagram illustrating another example of a bridge disposed in a glass core, applicable to a manufacturing method of a packaging substrate with an embedded bridge according to one embodiment of the present invention. FIGS. 3A through 3C are conceptual diagrams, each illustrating in cross-section an example patterning operation in a manufacturing method of a packaging substrate with an embedded bridge according to one embodiment of the present invention. FIG. 3D is a cross-sectional conceptual view illustrating the operations of forming an upper insulating cover after a patterning operation in a manufacturing method of a packaging substrate with an embedded bridge, according to one embodiment of the present invention. FIG. 4 is a cross-sectional conceptual diagram illustrating an example removal operation applied to a manufacturing method of a packaging substrate with an embedded bridge, according to one embodiment of the present invention. FIGS. 5A and 5B are conceptual diagrams illustrating an example of a packaging substrate in accordance with one embodiment of the present invention in cross-section, respectively. FIG. 6 is a conceptual diagram illustrating in cross-section an example of a packaging substrate with die mounted thereon, in accordance with one embodiment of the present invention. Referring to the above drawings, a method of manufacturing a packaging substrate with an embedded bridge will be described below.

To achieve the above objectives, a manufacturing method of a packaging substrate with an embedded bridge 1 according to one embodiment of the present disclosure provides a method of manufacturing a packaging substrate with bridge-embedded 1, comprising a preparation operation; a fixation operation; a patterning operation; and a removal operation.

The preparation operation is to prepare the glass core 20 having a cavity 24 and a core via 26.

The glass core 20 is a glass substrate (glass plate) having first and second faces facing each other, in which a cavity 24 and a core via 26 are arranged.

The cavity 24 may be a recessed surface formed in the glass core 20 (half cavity), or a portion of the glass plate is penetrated (full cavity), or both in the embodiments, and will be referred to as cavity 24 collectively.

The core vias 26 are vias formed through the glass plate in the direction of the thickness of the glass substrate. The core vias 26 may have circular openings but are not limited to, and the openings may have various shapes, such as oval, square, or other shapes, and may comprise a mixture of various shapes of openings within a single glass core.

The core vias 26 are vias through the glass substrate, inside of which an electrically conductive layer may be formed or filled with an electrically conductive material. The core vias 26 in this case are referred to as through-electrodes 42.

The glass core 20 may preferably be a glass substrate applicable to semiconductors, such as, but not limited to, a borosilicate glass substrate, an alkali-free glass substrate, and the like.

The glass core 20 in the preparation operation may be relatively thick, as opposed to the packaging substrate 1 after the removal stage. This is because a portion of the glass core is removed during the removal operation described below. The reason for applying such a thick glass core and removing a portion thereof will be described later.

The glass core 20 in the preparation operation may be a glass plate 22, a portion of which has been etched and treated to have a cavity 24 and a core via 26 (see FIG. 1A). Etching the glass plate 22 to form the cavity 24 and/or core vias 26 may exemplarily proceed as follows. First, the glass plate is prepared with defects formed at the locations where the cavities and/or core vias are to be formed. The formation of the defects may be accomplished by applying a laser or the like, but is not limited thereto. The glass plate is then chemically and/or physically etched. By etching, each part of the glass plate is etched at a different etching rate, and vias and cavities may be formed in the glass plate. In particular, chemical etching has the advantage that even when the area of the cavity is large or the number of core vias is large, the cavity and/or core vias may be formed with substantially no additional etching time, making the process more efficient.

The glass core 20 in the preparation operation may be an electrically conductive layer disposed on the glass plate 22. For example, the glass plate 22 may have an electrically conductive material disposed in a layer on the inner surface of the core via 26, or the inner surface of the core via 26 may be filled with an electrically conductive material. The electrically conductive material disposed on some or all of the interior of the core via 26 is referred to as the through-electrode 42.

The glass core 20 in the preparation operation may be a laminated glass comprising a first glass 23a having a cavity and a through-via; and a second glass 23b that is substantially free of through-cavity (full cavity) (see FIG. 1B). In this case, the first glass 23a has both a cavity and a through-via.

The penetrating vias of the first glass 23a may be through-electrodes 42. By performing the operations after the preparation operation with the first glass 23a having the through-electrode 42, the efficiency of the manufacturing method may be further improved.

The first glass 23a and the second glass 23b may be bonded and applied to the core via 26 in the above preparation operation. The bonding may be accomplished by any method of strongly bonding the two sheets of glass, for example, but not limited to, anodic bonding.

Exemplarily, the glass core 20 in the preparation operation may have a through-via pad 26p disposed at one or both ends of the through-electrode 42 disposed in the glass plate 22 or the first glass 23a. In this case, the process of forming the integrated electrode 46 described later may be simplified.

The fixation operation is the operation of positioning and fixing a bridge 70 in the cavity 24. The drawings from FIG. 2A onward illustrate the glass core 20 of FIG. 1A as an example, but the process below may be equally applicable to the glass core 20 of FIG. 1B.

The bridge 70 is a structure capable of carrying electrical signals between two or more dies. The dies are disposed on one side of the packaging substrate.

A bridge electrode 74 is disposed on the bridge 70, the bridge electrode 74 being located on the interior of the bridge 70. Further, an end of the bridge electrode 74 connects at least two points on one side of the bridge 70 to each other (see FIGS. 2A, 2B, etc).

The bridge 70 comprises a bridge core 72, which is a support; and a bridge electrode 74 disposed within the bridge core 72 and electrically connecting at least two points on a first surface of the bridge 70 to each other. The bridge electrode 74 may have both ends thereof exposed to a surface of the bridge core 72. Alternatively, a bridge electrode pad 74p associated with the bridge electrode 74 may be exposed to the surface of the bridge core 72.

Optionally, the bridge 70 may further comprise a bridge electrode pad 74p disposed on the bridge electrode 74. Specifically, the bridge electrode 74 may further comprise a bridge electrode pad 74p disposed on a first side of the bridge core 72 in connection with the bridge core 72 (see FIG. 2C).

The bridge core 72 may be a plate silicon or plate silicon carbide.

The bridge electrode 74, the bridge electrode pad 74p, and the like may be made of any material applied to the electrically conductive layer, and, for example, copper or a copper alloy may be applied, but is not limited to.

The fixing operation is an operation of securing one surface of the cavity 24 and one surface of the bridge 70 so that their positions do not change.

The fixation is carried out via a fixture 76. The fixture 76 physically and/or chemically fixes one side of the cavity 24 and one side of the bridge 70.

Exemplarily, the fixation operation may comprise fixing the position via a combining structure. In this case, no separate adhesive layer is formed on the underside of the bridge (physical fixation, see FIG 2A).

Exemplarily, the fixation operation may comprise placing an adhesive layer to fix the position (chemical fixation, see FIG. 2B). Exemplarily, the adhesive layer may be fixed by applying an adhesive to the surface to be adhesive, positioning the bridge 70 and allowing the adhesive to cure. Exemplarily, the adhesive layer may be applied in such a way that an adhesive layer disposed on one surface of the bridge is placed on the one surface of the cavity and fixed. The adhesive layer may be, but is not limited to, a silicone-based adhesive layer, an epoxy-based adhesive layer, and the like.

The adhesive layer may be removed from the packaging substrate after the removal operation described herein. The adhesive layer may remain in the packaging substrate after the removal operation described herein.

The patterning operation comprises arranging the integrated electrodes 46 on the glass core 20 and the bridge 70. In the space between the integrated electrodes 46, an insulating material 45 may be disposed.

The integrated electrode 46 is an electrically conductive layer that is electrically connected to at least one of the through-electrode 42 and the bridge electrode 74. The integrated electrode may be formed by a process of forming redistribution lines in a semiconductor process.

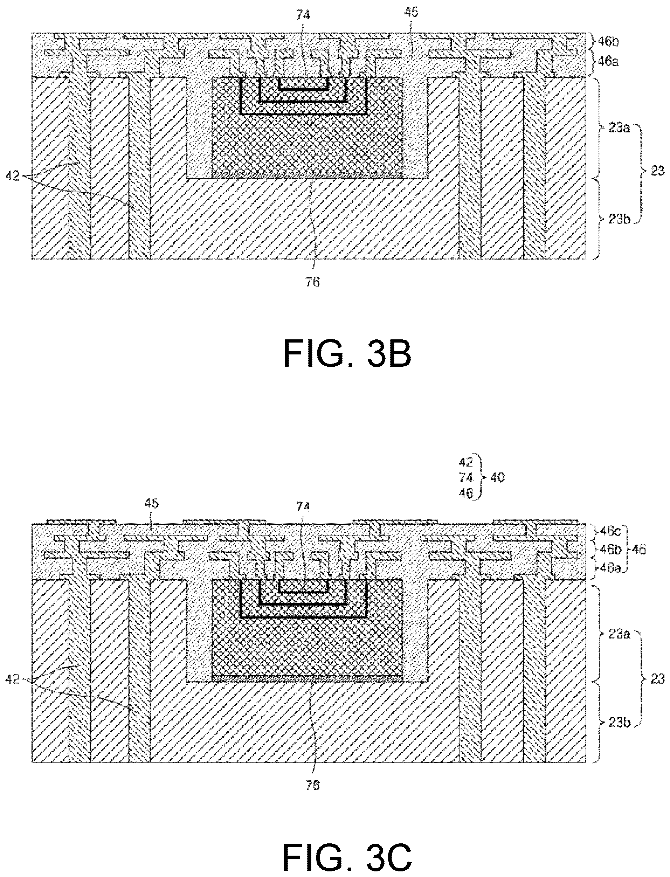

The patterning operation comprises forming a first integrated electrode 46a and a second integrated electrode 46b (see FIGS. 3A and 3B, respectively).

The patterning operation comprises forming a first integrated electrode 46a, a second integrated electrode 46b, and a third integrated electrode 46c (see FIG. 3A, FIG. 3B, and FIG. 3C, respectively).

The first integrated electrode 46a comprises a first vertically oriented electrically conductive layer, a first laterally oriented electrically conductive layer, and combinations thereof that are directly connected to the through-electrode 42 or the bridge electrode 74. They are also embedded by a first insulating material.

The second integrated electrode 46b is disposed over the first integrated electrode 46a.

The second integrated electrode 46b comprises a second vertically oriented electrically conductive layer, a second laterally oriented electrically conductive layer, and combinations thereof, which are connected to the electrically conductive layer of the first integrated electrode 46a. Further, they are embedded by a second insulating material.

The third integrated electrode 46c is disposed over the second integrated electrode 46b.

The third integrated electrode 46c comprises a third vertically oriented electrically conductive layer, a third laterally oriented electrically conductive layer, and combinations thereof, which are connected to the electrically conductive layer of the second integrated electrode 46b. Further, they are embedded by a third insulating material.

Optionally, a fourth integrated electrode, a fifth integrated electrode, and the like may be further formed on the third integrated electrode.

For example, the process of forming the integrated electrodes of each of the layers may be a process of forming a redistribution layer.

The glass core 20, which is the support of the packaging substrate 1, is characterized as fragile as glass plate. The glass plate may crack at the edges, or the glass plate itself may crack due to impact, internal stress, etc.

Cracking may also occur during the processing of glass plate into packaging substrates. Especially when forming a redistribution layer on a large area of glass plate, the repeated temperature rise and fall during the manufacturing process may concentrate stresses in the glass itself. Especially during the patterning operation, this process is repeated, and the stressed glass plate may be easily damaged by even small impacts.

The inventors have experimentally confirmed that such cracks tend to occur more easily when the thickness of the glass plate itself is small, and that glass cores with cavities are more difficult to process. To compensate for this, in an embodiment, the thickness of the glass plate itself is increased. In other words, the inventors present an embodiment in which a thicker glass core is applied to further reduce the occurrence of cracks even when a glass substrate with a cavity is applied.

Exemplarily, based on the thickness of the bridge 70, the thickness of the glass core 20 in the preparation operation may be more than 2 times, more than 3 times, more than 4 times, more than 5 times, or more than 6 times. The thickness may be 15 times or less, or 13 times or less.

For example, if the thickness of the bridge 70 is from about 50 µm to about 70 µm, the thickness of the glass core 20 in the preparation operation may be from about 400 µm to about 600 µm.

The patterning operation may comprise impregnating an insulating material into the glass core 20. The impregnation of the insulating material may also be carried out in the space between the cavity 24 and the bridge 70. Additionally, the insulating material may be incorporated into the space between the electrically conductive layers of the integrated electrode 46.

The insulating material may be an organic-inorganic composite material such as, but not limited to, Ajinomoto Build-up Film (ABF), Polyimide Build-up Film (PI Film), etc. The formation of the insulating material layer may be carried out by methods such as vacuum laminating and curing an uncured or semi-cured insulating material sheet, but is not limited thereto.

The electrically conductive layer may be copper, a copper alloy, or the like, but is not limited to. The formation of the electrically conductive layer may be achieved through methods such as plating on the required areas after the formation of the seed layer, but it is not limited to.

The removal operation is to remove the lower portion of the glass core 20 (see FIG. 4, arrow indicates direction of removal).

In this case, the lower portion of the glass core 20 does not mean up or down in position but refers to the opposite side of the layer on which the integrated electrode is formed in the patterning operation.

The glass core 20 is applied with a thicker thickness compared to the height of the cavity (etched depth), reducing the risk of damage during the fixation operation or the patterning operation, and ensuring stable process execution. However, since the thick thickness of the glass core 20 weighs down the packaging substrate itself and is contrary to the trend of semiconductor thinning, it is necessary to reduce the thickness. Therefore, in the embodiment, a removal operation is performed.

The removal operation comprises etching or grinding the lower portion of the glass core 20. The etching may be subjected to physical and/or chemical etching as described above. The grinding may exemplary be performed by a chemical mechanical polishing (CMP) process. The grinding may also be performed in the patterning operation. In the process of forming the redistribution layer, the insulating material layer and the electrically conductive layer are optionally plated in the form of a predetermined pattern, and grinding is also performed in this process.

In an embodiment, the glass core 20 that has undergone the patterning operation may be inverted and grinded with the grinder applied in the patterning operation.

The glass core 20 thus ground becomes thinner in thickness compared to the glass core 20 in the preparation operation, and a packaging substrate 1 having a bridge 70 in the cavity 24 may be obtained while having a relatively small thickness.

The glass core 20 is vertically divided into a portion in which the cavity 24 is disposed, and a portion in which the cavity 24 is not disposed.

The removal operation removes some or all of the portion where the cavity 24 is not disposed.

The above removal is applicable whether the glass core 20 is glass plate or laminated glass.

If a portion of the area where the cavity 24 is not disposed is removed through the removal process, the packaging substrate may take the form of having a half-cavity (not shown).

If all of the area where the cavity 24 is not disposed is removed through the removal process, the packaging substrate may take the form of having a full-cavity (see Fig. 4).

In the latter case, it may be in a first type in which the fixture 76, such as the adhesive layer, is also removed (see FIG 5a). Alternatively, it may be a second type in which the adhesive layer is left intact, and removal is performed to form a full cavity (see Fig. 5B).

In the case of the first type above, even if the fixture 76 is removed, the space between the wall surface of the cavity and the bridge 70 may be filled with an insulating material or the like and fixed, and the position of the bridge 70 may be maintained unchanged.

In the second form, the fixture 76 may be retained and the position of the bridge 70 may remain unchanged in that state.

Optionally, the manufacturing method of the packaging substrate may further comprise an operation of forming an insulating cover after the patterning operation but before the removal operation, or after the removal operation.

The operation of forming an insulating cover comprises forming an insulating cover over the integrated electrode 46 and/or under the glass substrate 20.

When an insulating cover is disposed over the integrated electrode 46, it is referred to as an upper insulating cover 83. The insulating cover may further comprise an upper connection 53 structure having openings disposed at predetermined locations and connecting to the die on which it is mounted (see FIG. 3D, FIG. 5A, FIG. 5B).

When an insulating cover is disposed below the glass substrate 20, it is referred to as a lower insulating cover 85. The insulating cover may have openings disposed at predetermined locations, and a lower connection 55 structure may be further disposed. The lower connection 55 may exemplarily be a solder ball or the like, but is not limited thereto (see FIGS. 5A, 5B).

The manufacturing method of the packaging substrate may further comprise a combining operation after the above removal operation.

The combining operation is the operation of placing the die 30 on the packaging substrate 1 and electrically connecting the circuit pattern 40 with the die 30. In this case, the connection is not only a direct connection, but also an indirect connection through another structure. The circuit pattern 40 collectively refers to the through-electrode 42, the bridge electrode 74, and the integrated electrode 46.

The two or more dies 30 comprise a first die 31 and a second die 33, and the combining operation mounts the first die 31 and the second die 33 at predetermined locations on the packaging substrate 1. While the drawings illustrate the placement of two dies, it is not limited to, two or more, three or more, or four or more dies may be disposed over the packaging substrate 1 in a single unit.

In other words, the packaging substrate 1 may further comprise a first die 31 and a second die 33 disposed over the integrated electrode 46. The packaging substrate 1 may comprise a bridge 70 such that electrical signals may be transmitted between the first die 31 and the second die 33 via the bridge electrode 74.

The manufacturing method of the packaging substrate may further comprise an encapsulating operation after the combining operation.

The encapsulating operation comprises placing a lead frame 87 on the die side of the packaging substrate 1 on which the dies are mounted, and filling the space within the lead frame 87 with an encapsulating material 81 (see FIG. 6). Through this, the position of the dies on the packaging substrate is fixed, providing a stabilized packaging substrate 1.

### Packaging Substrate with Embedded Bridge (1)

FIGS. 5A and 5B are conceptual diagrams illustrating an example of a packaging substrate in cross-section in accordance with one embodiment of the present invention, respectively, and FIG. 6 is a conceptual diagram illustrating an example of a packaging substrate with a die mounted thereon in cross-section in accordance with one embodiment of the present invention. With reference to FIGS. 5A through 6, a packaging substrate with an embedded bridge will be described in detail below.

A packaging substrate 1 with an embedded bridge according to one embodiment comprises a glass core 20 having a cavity 24 and a through-electrode 42; a bridge 70 disposed in the cavity 24; an integrated electrode 46 disposed on one surface of the bridge 70 and on one surface of the glass core 20; and an insulating material 45 disposed between the glass core 20 and the bridge 70 and between the integrated electrode 46.

The glass core 20 is a glass substrate (glass plate) having first and second faces facing each other, in which a cavity 24 and a core via 26 are arranged.

The cavity 24 may be a recessed surface formed in the glass core 20 (half cavity), or a portion of the glass plate is penetrated (full cavity). In the embodiments, both cases are in collectively referred to as the cavity 24.

The core vias 26 are vias formed through the glass plate in the direction of the thickness of the glass substrate. The core vias 26 may have circular openings, but are not limited to this, and the openings may have various shapes, such as oval, rectangular, or other shapes, and may comprise a mixture of various shapes of openings within a single glass core.

The core vias 26 are vias through the glass substrate, inside of which an electrically conductive layer may be formed or filled with an electrically conductive material. The core vias 26 in this case are referred to as through-electrodes 42.

The glass core 20 may preferably be a glass substrate applicable to semiconductors, such as, but not limited to, a borosilicate glass substrate, an alkali-free glass substrate, and the like.

The integrated electrode 46 is an electrically conductive layer electrically connected to at least one of the through-electrode 42 and the bridge electrode 74. The integrated electrode 46 is an electrically conductive layer arranged in a predetermined pattern with substantially vertical or horizontal connections.

In the space between the integrated electrodes 46, an insulating material 45 may be disposed.

The integrated electrode 46 comprises a first integrated electrode 46a disposed on the glass core 20 or the bridge 70; and a second integrated electrode 46b disposed on the first integrated electrode 46a.

The first integrated electrode 46a comprises a first vertically oriented electrically conductive layer in direct connection with the through-electrode 42 or bridge electrode 74, a first laterally oriented electrically conductive layer having a pattern extending in a lateral direction in connection with the first vertically oriented electrically conductive layer, and combinations thereof.

The second integrated electrode 46b comprises a second vertically oriented electrically conductive layer connected to the electrically conductive layer of the first integrated electrode 46a, a second laterally oriented electrically conductive layer having a pattern extending in a lateral direction in connection with the second vertically oriented electrically conductive layer, and combinations thereof.

The integrated electrode 46 may comprise a third integrated electrode 46c disposed on the second integrated electrode 46b.

The third integrated electrode 46c comprises a third vertically oriented electrically conductive layer connected to the electrically conductive layer of the second integrated electrode 46b, a third laterally oriented electrically conductive layer having a pattern extending in the lateral direction while connected to the third vertically oriented electrically conductive layer, and combinations thereof.

A bridge 70 comprises a bridge core 72, which is a support; and a bridge electrode 74 disposed within the bridge core 72 and electrically connecting at least two points on one surface of the bridge 70 to each other, both ends of which are exposed to the one surface of the bridge core 72.

The bridge 70 is a structure capable of carrying electrical signals between two or more dies. The dies are disposed on one side of the packaging substrate.

A bridge electrode 74 is disposed on the bridge 70, the bridge electrode 74 being located on the interior of the bridge 70. Further, an end of the bridge electrode 74 connects at least two points on one side of the bridge 70 to each other.

The bridge 70 comprises a bridge core 72, which is a support; and a bridge electrode 74 disposed within the bridge core 72 and electrically connecting at least two points on one surface of the bridge 70 to each other. The bridge electrode 74 may have both ends thereof exposed to a surface of the bridge core 72. Alternatively, a bridge electrode pad 74p associated with the bridge electrode 74 may be exposed to the surface of the bridge core 72.

The bridge 70 may optionally further comprise bridge through electrodes (not shown) electrically connecting the bridge core 72 up and down. When the bridge 70 further comprises bridge through electrodes, electrically conductive layers of various structures may be arranged in a smaller area, and packaging substrates may be more compactly and efficiently organized.

Optionally, the bridge 70 may further comprise a bridge electrode pad 74p disposed on the bridge electrode 74 and/or the bridge through electrode.

Specifically, the bridge electrode 74 may further comprise a bridge electrode pad 74p disposed on one side of the bridge core 72 in connection with the bridge core 72.

Specifically, the bridge penetrating electrode may further comprise a bridge electrode pad 74p disposed above or below the bridge core 72 in connection with the bridge through electrode.

The bridge core 72 may be a plate silicon (Si) or plate silicon carbide (SiC).

The bridge electrode 74, the bridge penetrating electrode 74t, the bridge electrode pad 74p, and the like may be made of any material applied to the electrically conductive layer, and may exemplarily be made of copper or a copper alloy, but is not limited thereto.

The fixture 76 may be disposed at a lower portion of the bridge 70.

The fixture 76 may be further included at the lower portion of the cavity 24, and the fixture 76 may be arranged to face the integrated electrode 46 with the bridge 70 in between.

The fixture 76 may be part of a combining structure, and may be an adhesive layer. The adhesive layer may be, but is not limited to, a silicone-based adhesive layer, an epoxy-based adhesive layer, or the like.

On top of the integrated electrode 46, an upper insulating cover 83 may be disposed.

A lower insulating cover 85 may be disposed on a lower portion of the glass core 20.

Between the bridge 70 and the lower insulating cover 85 may be positioned the fixture 76, exemplarily the fixture 76 may be an adhesive layer.

The upper insulating cover 83 may have an opening, and the upper connection 53 structure may be disposed in the opening.

The lower insulating cover 85 has an opening, under which the lower connection 55 structure may be disposed, for example, a solder ball.

The packaging substrate 1 may further comprise a first die 31 and a second die 33 disposed over the integrated electrode 46. The plurality of dies are collectively referred to as a die.

For example, a die may be a semiconductor device, a computing device such as a CPU or GPU, a memory device such as a memory, or the like.

The bridge 70 embedded in the packaging substrate 1 enables communication between the first die 31 and the second die 33 to proceed smoothly, resulting in a faster response time and lower power consumption. In addition, the bridge 70 is further arranged with bridge penetrating electrodes 74t passing through the top and bottom, which enables smoother signal transmission and efficient integration.

The packaging substrate 1 may further comprise: an encapsulating layer 81 wrapped around the first die 31 and the second die 33; and a lead frame 87 wrapped around the encapsulating layer 81. The encapsulating layer and the lead frame may be any encapsulating material and lead frame applicable to a packaging substrate without limitation.

The above-described bridge-embedded packaging substrate 1 provides a glass core-based packaging substrate capable of die-bridge connection in a compact size by applying a bridge 70 to the cavity 24 of the glass core 20. By utilizing the glass core while implementing the bridge connection, the relatively thin packaging substrate 1 with a cavity structure may be reliably manufactured by utilizing the glass core while having the advantage of having the characteristics of an insulating substrate and being able to be utilized as a support for fine conductors.

### Manufacturing method of packaging substrate having embedded bridge (2)

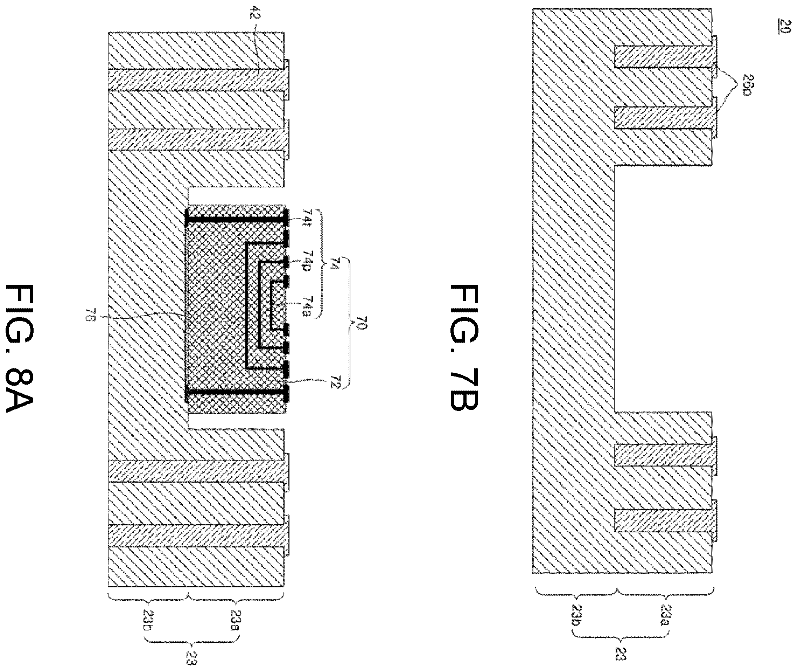

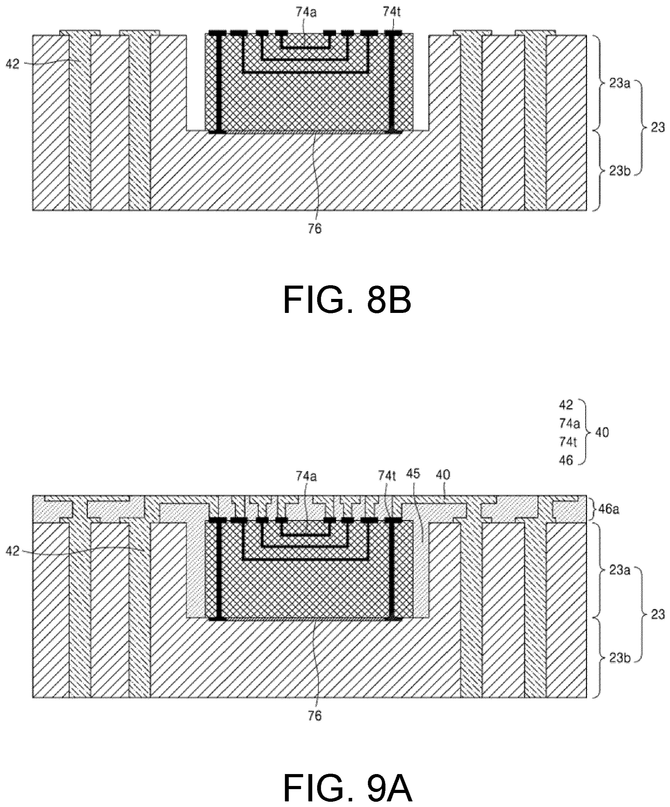

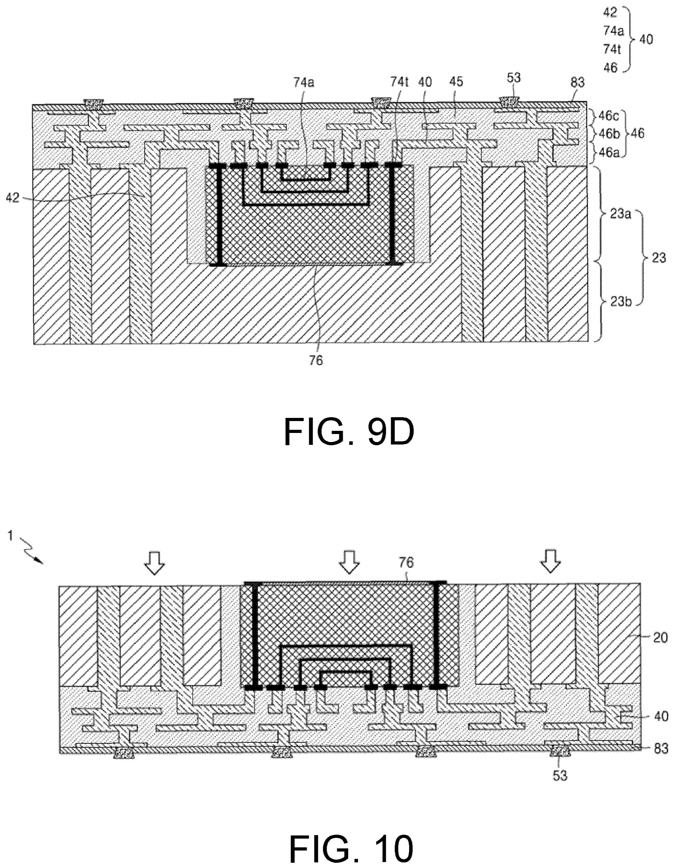

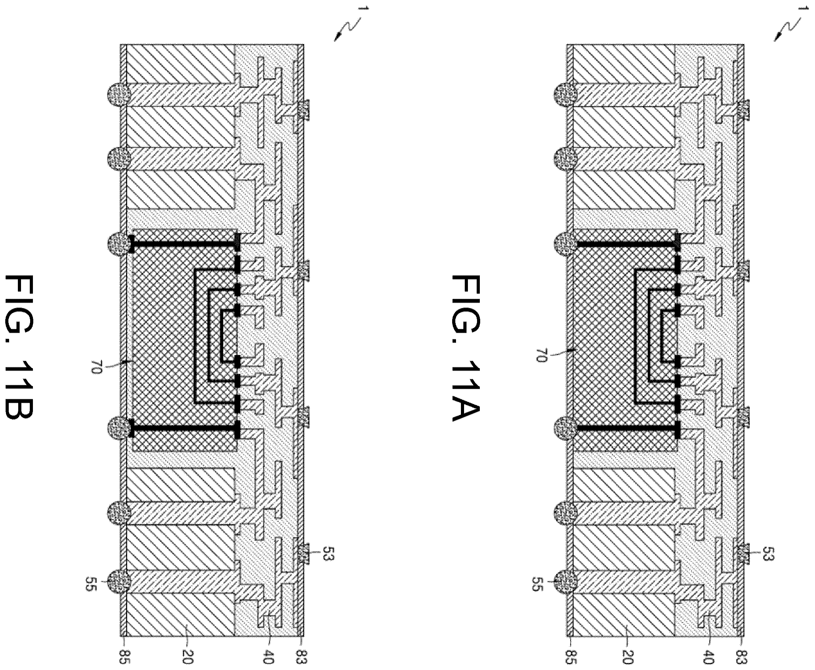

FIGS. 7A and 7B are conceptual views illustrating, in cross-section, an exemplary glass core applied to a manufacturing method of a packaging substrate having an embedded bridge, according to one embodiment of the present invention. FIG. 8A is a cross-sectional conceptual view illustrating an example of a bridge disposed in a glass core applicable to a manufacturing method of a packaging substrate having an embedded bridge, according to one embodiment of the present invention. FIG. 8B is a cross-sectional conceptual view illustrating another example of a bridge disposed in a glass core applicable to a manufacturing method of a packaging substrate having an embedded bridge according to one embodiment of the present invention. FIGS. 9A through 9C are conceptual views illustrating, in cross-section, an example patterning operation in a manufacturing method of a packaging substrate having an embedded bridge according to one embodiment of the present invention. FIG. 9D is a cross-sectional conceptual view illustrating the operations of forming an upper insulating cover after a patterning operation in a manufacturing method of a packaging substrate having an embedded bridge according to one embodiment of the present invention. FIG. 10 is a cross-sectional conceptual view illustrating an example removal operation applied to a manufacturing method of a packaging substrate having an embedded bridge according to one embodiment of the present invention. FIGS. 11A and 11B are conceptual views illustrating an example of a packaging substrate in accordance with one embodiment of the present invention in cross-section, respectively.

Referring to the above drawings, a manufacturing method of a packaging substrate having an embedded bridge will be described below.

To achieve the above objectives, a manufacturing method of a bridge-embedded packaging substrate 1 according to one embodiment of the present disclosure provides a manufacturing method of a bridge-embedded packaging substrate 1, comprises a preparation operation; a fixation operation; a patterning operation; and a removal operation.

The preparation operation is to prepare the glass core 20 having a cavity 24 and a core via 26.

The glass core 20 is a glass substrate (glass plate) having first and second faces facing each other, in which a cavity 24 and a core vias 26 are arranged.

The cavity 24 may be a recessed surface formed in the glass core 20 (half cavity), or a portion of the glass plate is penetrated (full cavity), or both in embodiments, and will be referred to as cavity 24 collectively.

The core vias 26 are vias formed through the glass plate in the direction of the thickness of the glass substrate. The core vias 26 may have circular openings, but are not limited thereto, and the openings may have various shapes, such as oval, rectangular, or the like, or a mixture of various shapes of openings within a single glass core.

The core vias 26 are vias through the glass substrate, inside of which an electrically conductive layer may be formed or filled with an electrically conductive material. The core vias 26 in this case are referred to as through-electrodes 42.

The glass core 20 may preferably be a glass substrate applicable to semiconductors, such as, but not limited to, a borosilicate glass substrate, an alkali-free glass substrate, and the like.

The glass core 20 in the preparation operation may have a relatively large thickness in contrast to the packaging substrate 1 after the removal stage. This is because a portion of the glass core is removed during the removal operation described below. The reason for applying such a thick glass core and removing a portion thereof will be described later.

The glass core 20 in the preparation operation may be a glass plate 22, a portion of which has been etched and treated to have a cavity 24 and a core via 26 (see FIG 7A). Etching the glass plate 22 to form the cavity 24 and/or core vias 26 may exemplarily proceed as follows. First, a glass plate is prepared with defects formed at the locations where the cavities and/or core vias are to be formed. The formation of the defects may be accomplished by applying a laser or the like, but is not limited thereto. The glass plate then chemically and/or physically etched. By etching, each part of the glass plate is etched at a different etching rate, and vias and cavities may be formed in the glass plate. In particular, chemical etching has the advantage that even when the area of the cavity is large or the number of core vias is large, the cavity and/or core vias may be formed with substantially no additional etching time, making the process more efficient.

The glass core 20 in the preparation operation may be an electrically conductive layer disposed on the glass plate 22. For example, the glass plate 22 may have an electrically conductive material disposed in a layer on the inner surface of the core via 26, or the inner surface of the core via 26 may be filled with an electrically conductive material. The electrically conductive material disposed on some or all of the interior of the core via 26 is referred to as the through-electrode 42.

The glass core 20 in the preparation operation may be a laminated glass comprising a first glass 23a having a cavity and a through-via; and a second glass 23b that is substantially free of through-via (full cavity) (see FIG 7B). In this case, the first glass 23a has both a cavity and a through-via.

The penetrating vias of the first glass 23a may be through-electrodes 42. By operations after the preparation operation with the first glass 23a having through-electrodes 42, the efficiency of the manufacturing method may be further improved.

The first glass 23a and the second glass 23b may be bonded and applied to the core via 26 in the above preparation operation. The bonding may be accomplished by any method of strongly bonding the two sheets of glass, for example, but not limited to, anodic bonding.

Exemplarily, the glass core 20 in the preparation operation may have a through-via pad 26p disposed at one or both ends of the through-electrode 42 disposed in the glass plate 22 or the first glass 23a. In this case, the process of forming the integrated electrode 46 described later may be simplified.

The fixation operation is the operation of positioning and fixing a bridge 70 in the cavity 24. The drawings from FIG. 8A onward illustrate the glass core 20 of FIG. 7A as an example, but the process below may be equally applicable to the glass core 20 of FIG. 7B.

The bridge 70 is a structure capable of carrying electrical signals between two or more dies. The dies are disposed on one side of the packaging substrate.

A bridge electrode 74 is disposed on the bridge 70, the bridge electrode 74 being located on the interior of the bridge 70. Further, an end of the bridge electrode 74 connects at least two points on one side of the bridge 70 to each other.

The bridge 70 comprises a bridge core 72, which is a support; and a bridge electrode 74a disposed inside the bridge core 72 and electrically connecting at least two points on a first surface of the bridge 70 to each other. The bridge electrode 74a may have both ends thereof exposed to a surface of the bridge core 72. Alternatively, a bridge electrode pad 74p associated with the bridge electrode 74a may be exposed to the surface of the bridge core 72.

Optionally, the bridge 70 may further comprise bridge penetrating electrodes 74t; electrically connecting the bridge core 72 up and down. When the bridge 70 further comprises the bridge penetrating electrodes 74t, electrically conductive layers of various structures may be arranged in a smaller area, and the packaging substrate may be more compactly and efficiently organized.

Optionally, the bridge 70 may further comprise a bridge electrode pad 74p disposed on the bridge electrode 74a and/or the bridge penetrating electrode 74t.

Specifically, the bridge electrode 74a may further comprise a bridge electrode pad 74p disposed on one face of the bridge core 72 in connection with the bridge core 72.

Specifically, the bridge penetrating electrode 74t may further comprise a bridge electrode pad 74p disposed in connection with the bridge penetrating electrode 74t on top or bottom of the bridge core 72.

The bridge core 72 may be a plate silicon or plate silicon carbide.

The bridge electrode 74a, the bridge penetrating electrode 74t, the bridge electrode pad 74p, and the like may be made of any material applied to the electrically conductive layer, and for example, copper or a copper alloy may be applied, but is not limited thereto.

The fixation operation is an operation of fixing the position of one surface of the cavity 24 and one surface of the bridge 70 so that it does not change.

The fixation is carried out via a fixture 76. The fixture 76 physically and/or chemically fixes one side of the cavity 24 and one side of the bridge 70.

Exemplarily, the fixation operation may comprise fixing the position via a combining structure. In this case, no separate adhesive layer is formed on the underside of the bridge (physical fixation, see FIG 8A).

Exemplarily, the fixation operation may comprise placing an adhesive layer to fix the position (chemical fixation, see FIG. 8B). Exemplarily, the adhesive layer may be fixed by applying an adhesive to the adhesive surface, positioning the bridge 70 and allowing the adhesive to cure. Exemplarily, the adhesive layer may be applied in such a way that an adhesive layer disposed on one face of the bridge is placed on the one surface of the cavity and fixed. The adhesive layer may be, but is not limited to, a silicone-based adhesive layer, an epoxy-based adhesive layer, and the like.

The adhesive layer may be removed from the packaging substrate after the removal operation described herein. The adhesive layer may remain in the packaging substrate after the removal operation described herein.

The patterning operation comprises arranging the integrated electrodes 46 on the glass core 20 and the bridge 70. In the space between the integrated electrodes 46, an insulating material 45 may be disposed.

The integrated electrode 46 is an electrically conductive layer that is electrically connected to at least one of the through-electrode 42, the bridge electrode 74a, and the bridge penetrating electrode 74t. The integrated electrode may be formed by a process of forming redistribution lines in a semiconductor process.

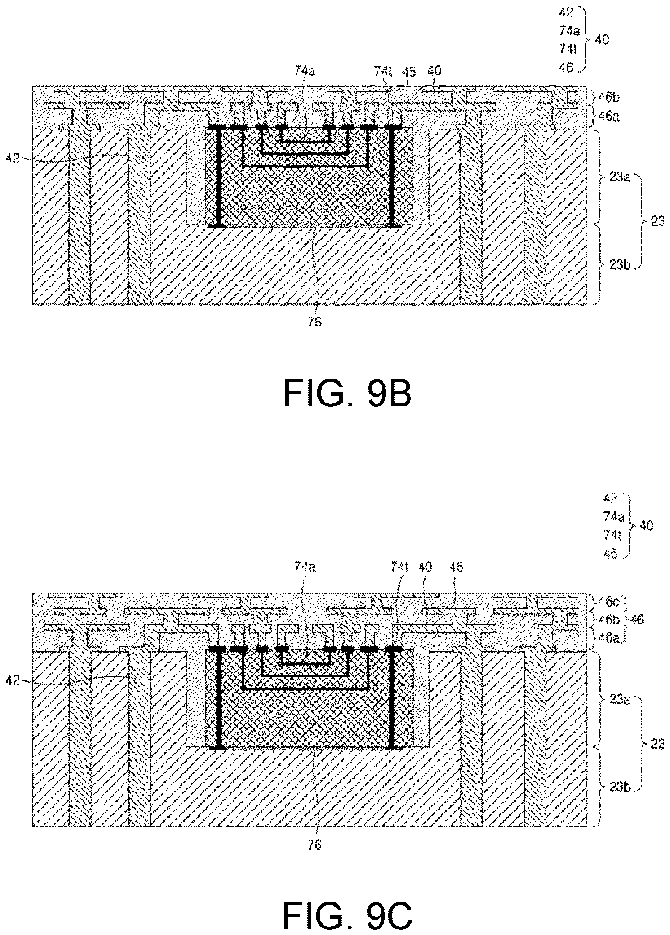

The patterning operation comprises forming a first integrated electrode 46a and a second integrated electrode 46b (see FIGS. 9A and 9B, respectively).

The patterning operation comprises forming a first integrated electrode 46a, a second integrated electrode 46b, and a third integrated electrode 46c (see FIG. 9A, FIG. 9B, and FIG. 9C, respectively).

The first integrated electrode 46a comprises a first vertically oriented electrically conductive layer, a first laterally oriented electrically conductive layer, and combinations thereof that are directly connected to the through-electrode 42 or the bridge electrode 74. They are also embedded by a first insulating material.

The second integrated electrode 46b is disposed on the first integrated electrode 46a above.

The second integrated electrode 46b comprises a second vertically oriented electrically conductive layer, a second laterally oriented electrically conductive layer, and combinations thereof, which is connected to the electrically conductive layer of the first integrated electrode 46a. Further, they are embedded by a second insulating material.

The third integrated electrode 46c is disposed above the second integrated electrode 46b.

The third integrated electrode 46c comprises a third vertically oriented electrically conductive layer, a third laterally oriented electrically conductive layer, and combinations thereof, which are connected to the electrically conductive layer of the second integrated electrode 46b. Further, they are embedded by a third insulating material.

Optionally, a fourth integrated electrode, a fifth integrated electrode, and the like may be further formed on the third integrated electrode.

For example, the process of forming the integrated electrodes of each of the layers may be a process of forming a redistribution layer.

The glass core 20, which is the support of the packaging substrate 1, is characterized as fragile as glass plate. The glass plate may crack at the edges or the glass plate itself may crack due to impact, internal stress, etc.

Cracking may also occur during the processing of glass plate into packaging substrates. Especially when forming a redistribution layer on a large area of glass plate, the repeated temperature rise and fall during the manufacturing process may concentrate stresses in the glass itself. Especially during the patterning operation, this process is repeated, and the stressed glass plate may be easily damaged by even small impacts.

The inventors have experimentally confirmed that such cracking tends to occur more easily when the thickness of the glass plate itself is small, and that glass cores with cavities are more difficult to process. To compensate for this, in an embodiment, the thickness of the glass plate itself is increased. In other words, the inventors present an embodiment in which a thicker glass core is applied to further reduce the occurrence of cracks even when a glass substrate with a cavity is applied.

Exemplarily, based on the thickness of the bridge 70, the thickness of the glass core 20 in the preparation operation may be at least 2 times, at least 3 times, at least 4 times, at least 5 times, or at least 6 times. The thickness may be 15 times or less, or 13 times or less.

For example, if the thickness of the bridge 70 is from about 50 micrometer to about 70 micrometer, the thickness of the glass core 20 in the preparation operation may be from about 400 micrometer to about 600 micrometer.

The patterning operation may comprise impregnating an insulating material into the glass core 20. The impregnation of the insulating material may also be carried out in the space between the cavity 24 and the bridge 70. Additionally, the insulating material may be incorporated into the space between the electrically conductive layers of the integrated electrode 46.

The insulating material may be an organic-inorganic composite material such as ABF (Ajinomoto Build-up Film), PI film (Polyimide Build-up Film), etc. The formation of the insulating material layer may be by, but is not limited to, pressure sensitive and curing of uncured or semi-cured insulating material sheets.

The electrically conductive layer may be copper, a copper alloy, or the like, but is not limited thereto. The formation of the electrically conductive layer may be by plating the required area after forming the seed layer, but it is not limited thereto.

The removal operation is to remove the lower portion of the glass core 20 (see FIG. 10, arrow indicates direction of removal).

In this case, the lower portion of the glass core 20 does not mean up or down in position, but refers to the opposite side of the layer on which the integrated electrode is formed in the patterning operation.

The glass core 20 is applied with a thicker thickness compared to the height of the cavity (etched depth), reducing the risk of damage during the fixation operation and/or the patterning operation, and ensuring stable process execution. However, since the thick thickness of the glass core 20 weighs down the packaging substrate itself and is contrary to the trend of semiconductor thinning, it is necessary to reduce the thickness. Therefore, in the embodiment, a removal operation is performed.

The removal operation comprises etching or grinding the lower portion of the glass core 20. The etching may be subjected to physical and/or chemical etching as described above. The grinding may be exemplarily performed by a chemical mechanical polishing (CMP) process. The grinding may also be performed in a patterning operation. In the process of forming the redistribution layer, the insulating material layer and the electrically conductive layer are optionally plated in the form of a predetermined pattern, and grinding is also performed in this process.

In an embodiment, the glass core 20 that has undergone the patterning operation may be inverted and grinded with the grinder applied in the patterning operation.

The grinded glass core 20 becomes thinner in thickness compared to the glass core 20 in the preparation operation, and a packaging substrate 1 having a bridge 70 in the cavity 24 may be obtained while having a relatively small thickness.

The glass core 20 is divided into a portion in which the cavity 24 is disposed upwardly and downwardly, and a portion in which the cavity 24 is not disposed.

The removal operation removes some or all of the portion where the cavity 24 is not disposed.

The removal is applicable whether the glass core 20 is glass plate or laminated glass.

If the removal removes a portion of the portion in which the cavity 24 is not disposed, the packaging substrate will be in the form of having a half-cavity (not shown).

If the removal removes all of the portion where the cavity 24 is not disposed, the packaging substrate is in a form having a full cavity (see FIG. 10).

In the latter case, it may be in a first type, where the fixture 76, such as the adhesive layer, is also removed (see Figure 11A). Alternatively, it may be a second type, where the adhesive layer is left in place and removed to become a full cavity (see Figure 11B).

In the case of the first type above, even if the fixture 76 is removed, the space between the wall surface of the cavity and the bridge 70 may be filled with an insulating material or the like and fixed, and the position of the bridge 70 may be maintained unchanged.

In the second type, the fixture 76 may be retained and the position of the bridge 70 may remain unchanged in that state.

Optionally, the manufacturing method of the packaging substrate may further comprise an operation of forming an insulating cover after the patterning operation but before the removal operation; or after the removal operation.

The operation of forming an insulating cover is a progress of forming an insulating cover over the integrated electrode 46; and/or under the glass substrate 20.

When an insulating cover is disposed over the integrated electrode 46, it is referred to as an upper insulating cover 83. The insulating cover may further comprise an upper connection 53 structure having openings disposed at predetermined locations and connecting to the die on which it is mounted (see FIG. 9D, FIG. 11A, FIG. 11B).

When an insulating cover is disposed below the glass substrate 20, it is referred to as a lower insulating cover 85. The insulating cover may have openings disposed at predetermined locations, and a lower connection 55 structure may be further disposed. The lower connection 55 may exemplarily be a solder ball or the like, but is not limited thereto (see FIGS. 11A, 11B).

The manufacturing method of the packaging substrate may further comprise a coupling operation after the above removal operation.

The coupling operation is the operation of placing the die 30 on the packaging substrate 1 and electrically connecting the circuit pattern 40 with the die 30. In this case, the coupling is not only a direct connection, but also an indirect connection through another structure. The circuit pattern 40 also refers to the through electrode 42, the bridge electrode 74, and the integrated electrode 46.

The two or more dies 30 comprise a first die 31 and a second die 33, and the coupling operation mounts the first die 31 and the second die 33 at predetermined locations on the packaging substrate 1. While the drawings illustrate the arrangement of two dies, two or more, three or more, or four or more dies may be disposed on the packaging substrate 1 of a single unit, without limitation.

In other words, the packaging substrate 1 may further comprise a first die 31 and a second die 33 disposed on the integrated electrode 46. The packaging substrate 1 may have a bridge 70 embedded therein such that electrical signals may be transmitted between the first die 31 and the second die 33 via the bridge electrode 74a.

The manufacturing method of the packaging substrate may further comprise an encapsulating operation after the coupling operation.

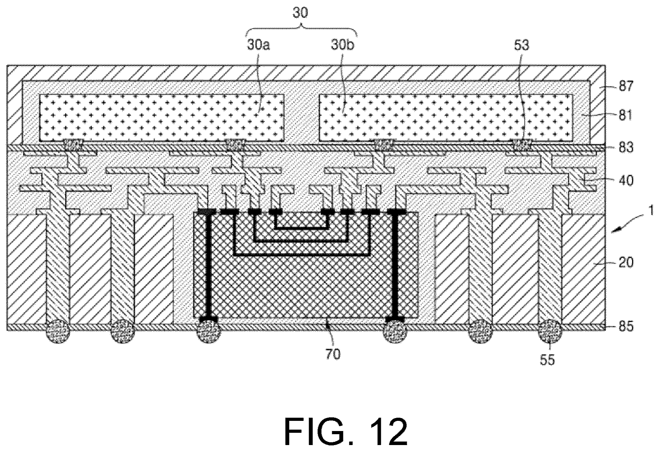

The encapsulating operation comprises placing a lead frame 87 on the die side of the packaging substrate 1 on which the dies are mounted, and filling the space within the lead frame 87 with am encapsulating material 81 (see FIG. 12). This provides a packaging substrate 1 in which the position of the die on the packaging substrate is fixed and stabilized.

### Packaging substrates with embedded bridges (2)

FIGS. 11A and 11B are conceptual views illustrating an example of a packaging substrate in accordance with one embodiment of the present invention in cross-section, respectively, and FIG. 12 is a conceptual view illustrating an example of a packaging substrate with a die mounted thereon in accordance with one embodiment of the present invention in cross-section. With reference to FIGS. 11A through 12, a packaging substrate having an embedded bridge will be described in detail below.

A packaging substrate 1 with an embedded bridge according to one embodiment comprises a glass core 20 having a cavity 24 and a through-electrode 42; a bridge 70 disposed in the cavity 24; an integrated electrode 46 disposed on a first surface of the bridge 70 and on a first surface of the glass core 20; and an insulating material 45 disposed between the glass core 20 and bridge 70 and between the integrated electrode 46.

The glass core 20 is a glass substrate (glass plate) having first and second faces facing each other, in which a cavity 24 and a core via 26 are arranged.

The cavity 24 may be a recessed surface formed in the glass core 20 (half cavity), or a portion of the glass plate is penetrated (full cavity), or both in some embodiments, and will be referred to as cavity 24 collectively.

The core vias 26 are vias formed through the glass plate in the direction of the thickness of the glass substrate. The core vias 26 may have circular openings, but are not limited to this, and the openings may have various shapes, such as oval, rectangular, or other shapes, and may comprise a mixture of various shapes of openings within a single glass core.

The core vias 26 are vias through the glass substrate, inside of which an electrically conductive layer may be formed or filled with an electrically conductive material. The core vias 26 in this case are referred to as through-electrodes 42.

The glass core 20 may preferably be a glass substrate applicable to semiconductors, such as, but not limited to, a borosilicate glass substrate, an alkali-free glass substrate, and the like.

The integrated electrode 46 is an electrically conductive layer electrically connected to at least one of the through electrode 42, the bridge electrode 74a, and the bridge penetrating electrode 74t. The integrated electrode 46 is an electrically conductive layer arranged in a predetermined pattern with substantially vertical or horizontally oriented connections.

In the space between the integrated electrodes 46, an insulating material 45 may be disposed.

The integrated electrode 46 comprises a first integrated electrode 46a disposed on the glass core 20 or the bridge 70; and a second integrated electrode 46b disposed on the first integrated electrode 46a.

The first integrated electrode 46a comprises a first vertically oriented electrically conductive layer in direct connection with the through-electrode 42 or bridge electrode 74, a first laterally oriented electrically conductive layer having a pattern extending in a lateral direction in connection with the first vertically oriented electrically conductive layer, and combinations thereof.

The second integrated electrode 46b comprises a second vertically oriented electrically conductive layer connected to the electrically conductive layer of the first integrated electrode 46a, a second laterally oriented electrically conductive layer having a pattern extending in a lateral direction in connection with the second vertically oriented electrically conductive layer, and combinations thereof.

The integrated electrode 46 may comprise a third integrated electrode 46c disposed on the second integrated electrode 46b.

The third integrated electrode 46c comprises a third vertically oriented electrically conductive layer connected to the electrically conductive layer of the second integrated electrode 46b, a third laterally oriented electrically conductive layer having a pattern extending in the lateral direction while connected to the third vertically oriented electrically conductive layer, and combinations thereof.

The bridge 70 comprises: a bridge core 72, which is a support; a bridge electrode 74a disposed inside the bridge core 72 and electrically connecting at least two points on a first surface of the bridge 70 to each other, both ends of which are exposed to a surface of the bridge core 72; and a bridge penetrating electrode 74t, which penetrates and electrically connects up and down the bridge core 72.

The bridge 70 is a structure capable of carrying electrical signals between two or more dies. The dies are disposed on one side of the packaging substrate.

A bridge electrode 74 is disposed on the bridge 70, the bridge electrode 74 being located on the interior of the bridge 70. Further, an end of the bridge electrode 74 connects at least two points on one side of the bridge 70 to each other.

The bridge 70 comprises a bridge core 72, which is a support; and a bridge electrode 74a disposed inside the bridge core 72 and electrically connecting at least two points on a first surface of the bridge 70 to each other. The bridge electrode 74a may have both ends thereof exposed to a surface of the bridge core 72. Alternatively, a bridge electrode pad 74p associated with the bridge electrode 74a may be exposed to the surface of the bridge core 72.

The bridge 70 may further comprise bridge penetrating electrodes 74t; electrically connecting the bridge core 72 up and down. When the bridge 70 further comprises bridge penetrating electrodes 74t, electrically conductive layers of various structures may be arranged in a smaller area, and the packaging substrate may be more compactly and efficiently organized.

Optionally, the bridge 70 may further comprise a bridge electrode pad 74p disposed on the bridge electrode 74a and/or the bridge penetrating electrode 74t.

Specifically, the bridge electrode 74a may further comprise a bridge electrode pad 74p disposed on a first side of the bridge core 72 in connection with the bridge core 72.

Specifically, the bridge penetrating electrode 74t may further comprise a bridge electrode pad 74p disposed in connection with the bridge penetrating electrode 74t on an upper or lower portion of the bridge core 72.

The bridge core 72 may be a plate silicon (Si) or plate silicon carbide (SiC).

The bridge electrode 74a, the bridge penetrating electrode 74t, the bridge electrode pad 74p, and the like may be made of any material applied to the electrically conductive layer, and for example, copper or a copper alloy may be applied, but is not limited thereto.

The fixture 76 may be disposed at a lower portion of the bridge 70.

The lower portion of the cavity 24 may further comprise a fixture 76, the fixture 76 being disposed across the bridge 70 and facing the integrated electrode 46.

The fixture 76 may be part of a combining structure, and may be an adhesive layer. The adhesive layer may be, but is not limited to, a silicone-based adhesive layer, an epoxy-based adhesive layer, or the like.

On top of the integrated electrode 46, an upper insulating cover 83 may be disposed.

A lower insulating cover 85 may be disposed on a lower portion of the glass core 20.

Between the bridge 70 and the lower insulating cover 85 may be positioned the fixture 76, exemplarily the fixture 76 may be an adhesive layer.

The upper insulating cover 83 may have an opening, and the upper connection structure 53 may be disposed in the opening.

The lower insulating cover 85 has an opening, under which the lower connection structure 55 may be disposed, for example, a solder ball.

The packaging substrate 1 may further comprise a first die 31 and a second die 33 disposed on the integrated electrode 46. The plurality of dies are collectively referred to as dies.

For example, a die may be a semiconductor element, a computing device such as a CPU or GPU, a memory device such as a memory, or the like.

The bridge 70 embedded in the packaging substrate 1 enables communication between the first die 31 and the second die 33 to proceed smoothly, resulting in a faster response time and lower power consumption. In addition, the bridge 70 is further arranged with bridge penetrating electrodes 74t passing through the top and bottom, which enables smoother signal transmission and efficient integration.

The packaging substrate 1 may further comprise: an encapsulating layer 81 wrapped around the first die 31 and the second die 33; and a lead frame 87 wrapped around the encapsulating layer 81. The encapsulating layer and the lead frame may be any encapsulating material and lead frame applied to a packaging substrate.

The above-described bridge-embedded packaging substrate 1 provides a glass core-based packaging substrate capable of die-bridge connection in a compact size by applying a bridge 70 to the cavity 24 of the glass core 20. By utilizing the glass core while implementing the bridge connection, the relatively thin packaging substrate 1 with a cavity structure may be reliably manufactured by utilizing the glass core while having the advantage of having the characteristics of an insulating substrate and being able to be utilized as a support for fine conductors.

A packaging substrate having an embedded bridge in an embodiment and its manufacturing method may provide a packaging substrate with improved power efficiency by applying a structure that incorporates a bridge within the substrate. Additionally, it offers a manufacturing method for a packaging substrate with an embedded bridge inside a glass panel, overcoming the processing challenges of glass plates.

While preferred embodiments of the present invention have been described in detail above, the scope of the present invention is not limited thereto, and various modifications and improvements by those skilled in the art utilizing the basic concepts of the present invention as defined by the following claims are also within the scope of the present invention.

## Claims

1. A packaging substrate with an embedded bridge, comprising:
a glass core having a cavity and a through-electrode;
a bridge disposed in the cavity;
an integrated electrode disposed on one surface of the bridge and on one surface of the glass core; and
an insulating material disposed between the glass core and the bridge, and between the integrated electrode,
wherein the bridge comprises:
a bridge core, which is a support; and
a bridge electrode disposed within the bridge core, which electrically connects at least two points on the one surface of the bridge and has both ends exposed on a surface of the bridge core, and
wherein the integrated electrode is an electrically conductive layer electrically coupled to at least one of the through-electrode and the bridge electrode.

2. The packaging substrate with an embedded bridge of claim 1, further comprising a fixture at a lower portion of the cavity, and
wherein the fixture is disposed to face the integrated electrode with the bridge in between.

3. The packaging substrate with an embedded bridge of claim 1 or claim 2,
wherein the packaging substrate comprises a first die and a second die disposed over a circuit pattern, and
an electrical signal between the first die and the second die is transmitted via the bridge electrode.

4. The packaging substrate with an embedded bridge of any one from claim 1 to claim 3,
wherein the integrated electrode comprises:
a first integrated electrode disposed over the glass core or the bridge; and
a second integrated electrode disposed over the first integrated electrode,
wherein the first integrated electrode comprises a first vertically oriented electrically conductive layer and a first laterally oriented electrically conductive layer directly connected to the through-electrode or the bridge electrode, and
the second integrated electrode comprises a second vertically oriented electrically conductive layer and a second laterally oriented electrically conductive layer connected to the electrically conductive layer of the first integrated electrode.

5. The packaging substrate with an embedded bridge of claim 2,
wherein a lower insulating cover is disposed over a lower portion of the glass core,
the fixture is located between the bridge and the lower insulating cover, and
the fixture comprises an adhesive layer.

6. The packaging substrate with an embedded bridge of claim 3, further comprising an encapsulating layer wrapping the first die and the second die, and
a lead frame covering the encapsulating layer.

7. The packaging substrate with an embedded bridge of any one from claim 1 to claim 6,
wherein the bridge further comprises a bridge penetrating electrode,
wherein the bridge penetrating electrode penetrates vertically through the bridge core,
wherein the integrated electrode is a conductive layer electrically connected to at least one of the through-electrode, the bridge electrode, and the bridge penetrating electrode.

8. The packaging substrate with an embedded bridge according to any one from claim 1 to claim 7,
wherein the bridge core comprises plate-shaped silicon or plate-shaped silicon carbide.

9. The packaging substrate with an embedded bridge according to claim 4,
wherein the integrated electrode further comprises a third integrated electrode disposed over the second integrated electrode,
wherein the third integrated electrode comprises a third vertical conductive layer, a third lateral conductive layer, or a combination thereof, connected to the conductive layer of the second integrated electrode.

10. The packaging substrate with an embedded bridge according to claim 7,
wherein the bridge penetrating electrode further comprises a bridge electrode pad disposed on an upper or lower surface of the bridge core.

11. The packaging substrate with an embedded bridge according to any one from claim 1 to claim 10,
wherein the glass core is a glass plate etched to comprise the cavity and core vias.

12. A manufacturing method for a packaging substrate with an embedded bridge, comprising
a preparation operation of preparing a glass core having a cavity and a core via;
a fixation operation of disposing a bridge in the cavity and fixing its position;
a patterning operation of disposing a circuit pattern on the glass core and the bridge; and
a removal operation of removing a lower portion of the glass core,
whereby the packaging substrate with an embedded bridge according to claim 1 is manufactured.

13. The manufacturing method for a packaging substrate with an embedded bridge of claim 12,
wherein the fixation operation is a fixing process by forming an adhesive layer between one surface of the cavity and one surface of the bridge.

14. The manufacturing method for a packaging substrate with an embedded bridge of claim 12 or claim 13,
wherein the glass core is vertically divided into a first portion, in which the cavity is disposed, and a second portion, in which the cavity is not disposed, and
the removal operation includes a removing process of a part or an entirety of the second portion.

15. The manufacturing method for a packaging substrate with an embedded bridge of any one from claim 12 to claim 14,
wherein the glass core is a laminated glass formed by bonding a first glass and a second glass,
the first glass comprises the cavity and through-vias, and
the second glass is not provided with a through-cavity.
